Europäisches Patentamt

European Patent Office

Office européen des brevets

(11) Veröffentlichungsnummer: **0 299 454 B1**

(12) **EUROPÄISCHE PATENTSCHRIFT**

(45) Veröffentlichungstag der Patentschrift: **25.03.92**

(51) Int. Cl.⁵: **H05K 3/46**

(21) Anmeldenummer: **88111216.3**

(22) Anmeldetag: **13.07.88**

(54) **Verfahren zur Herstellung von gedruckten Schaltungen in starrer oder starrflexibler Mehrlagentechnik.**

(30) Priorität: **15.07.87 DE 3723414**

(43) Veröffentlichungstag der Anmeldung:
**18.01.89 Patentblatt 89/03**

(45) Bekanntmachung des Hinweises auf die
Patenterteilung:
**25.03.92 Patentblatt 92/13**

(84) Benannte Vertragsstaaten:
**CH DE FR GB LI**

(56) Entgegenhaltungen:
DE-A- 3 541 977
US-A- 3 606 677

(73) Patentinhaber: **Vaas-Lt GmbH**
**Güglingstrasse 47**
**W-7070 Schwäbisch Gmünd(DE)**

(72) Erfinder: **Stohrer, Günther**
**Brühlstrasse 20**
**W-7340 Geislingen 5(DE)**
Erfinder: **Balla, Gerhard, Dipl.-Ing.**
**Panoramastrasse 8**
**W-7341 Amstetten(DE)**

(74) Vertreter: **Schwabe - Sandmair - Marx**
**Stuntzstrasse 16**
**W-8000 München 80(DE)**

## Beschreibung

Die Erfindung betrifft ein Verfahren zur Herstellung von Gedruckten Schaltungen in starrer oder starrflexibler Mehrlagentechnik, wonach unter Verwendung von Klebemittel, insbesondere Klebefolien ein Laminat, welches eine oder mehrere Leiterbildschichten, eine oder mehrere Klebemittelschichten und gegebenenfalls Schutz- oder Deckschichten enthält, unter Anwendung von Druck und Temperatur hergestellt wird.

Ein derartiges Verfahren zur Herstellung von Gedruckten Schaltungen ist bereits bekannt (siehe z.B. US-A-3 606 677). Um bei diesem bekannten Herstellungsverfahren zu verhindern, daß während des Laminiervorganges unter Anwendung von Druck und Temperatur das Harz der verwendeten Klebefolien nicht auf die flexiblen Teile übertritt, werden im allgemeinen Klebefolien mit geringem oder keinem beobachtbaren Harzfluß eingesetzt wie beispielsweise sogenannte Noflow-Prepregs aus reaktivem, glasfaserverstärktem Epoxidmaterial oder auch Klebefolien auf reiner Acrylat-oder Polyesterharzbasis.

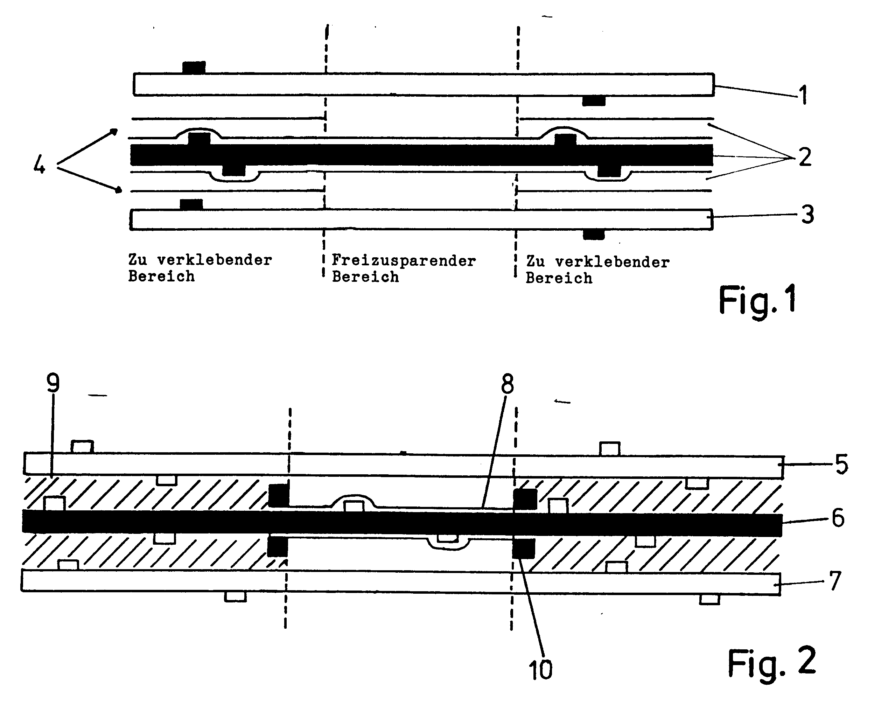

Eine nach dem bekannten Verfahren hergestellte Gedruckte Schaltung in Mehrlagentechnik ist in Figur 1 gezeigt. Diese Gedruckte Schaltung umfaßt einen Außenkern 1 mit Leiterbild, ferner einen flexiblen Innenkern 2 mit Leiterbild und vorgepreßter Deckfolie und schließlich einen Außenkern 3 mit Leiterbild. Mit 4 ist eine nichtfließende oder nur geringfließende Klebefolie bezeichnet. Eine derartige Gedruckte Schaltung in Mehrlagentechnik kann beispielsweise aus einer Anzahl n flexibler und einer Anzahl m starrer Lagen bestehen, wobei n = 0,1,2,3,4,... und m = 0,1,2,3,4, ..., das heißt jede ganze Zahl größer oder gleich 0 sein kann.

Dem bekannten Verfahren zur Herstellung von Gedruckten Schaltungen in starrer oder starrflexibler Mehrlagentechnik haften jedoch einige einschneidende Nachteile an:

a) Bei Verwendung von Klebefolien auf reiner Acrylat-oder Polyesterbasis ist der spätere Verbund der hergestellten Mehrlagenschaltung durch eine erhöhte thermische Sensibilität gekennzeichnet. Wärmeeinwirkungen jeglicher Art, wie sie zum Beispiel beim Löten von elektrischen Baugruppen oder während des Betriebes eines betreffenden Gerätes durch Verlustwärme auftreten, können zu einem frühzeitigen Ausfall elektrischer Durchkontaktierungen in der Mehrlagenschaltung aufgrund von Hüllenrissen führen.

b) Werden bei dem bekannten Verfahren Klebefolien aus glasfaserverstärktem Epoxidmaterial, also sogenannte Noflow-Prepregs eingesetzt, so reicht deren Harzfluß während des Laminierprozesses meist nicht aus, um die Zwischenräume eines meist vorhandenen Leiterbilds auf den Innenlagen einer Mehrbenenschaltung vollständig mit Harz zu füllen, so daß wiederum zusätzlich mit Deckfolien, die zum Beispiel mit Acrylatkleber beschichtet sind, gearbeitet werden muß, wobei der bereits unter a) erläuterte Nachteil wiederum auftritt.

Außerdem werden derzeit die sogenannten Nowflow-Prepregs nur auf Basis einer Epoxid- oder modifizierten Epoxid-Harzmatrix hergestellt, während zum Beispiel hochtemperaturbeständige Nowflow-Prepregs nicht eingesetzt werden, die aus Polyimidharz bestehen.

Die der Erfindung zugrunde liegende Aufgabe besteht darin, ein Verfahren zur Herstellung von Gedruckten Schaltungen in starrer oder starrflexibler Mehrlagentechnik zu schaffen, welches die Möglichkeit bietet, die Gedruckten Schaltungen mit verbesserter Zuverlässigkeit unabhängig von den Eigenschaften der verwendeten Klebefolien herstellen zu können.

Ausgehend von dem Verfahren der eingangs genannten Art wird diese Aufgabe erfindungsgemäß dadurch gelöst, daß zumindest ein Teil der Umgebung von Abschnitten des Laminats, die vor einer Klebemittelbenetzung zu schützen sind, mit einem Klebemittel versehen wird, welches bei der Temperatur- und Druckbeeinflussung einen endlichen Klebemittelfluß hat, der gleich oder kleiner 5% ist.

Mit Hilfe des erfindungsgemäßen Verfahrens lassen sich Gedruckte Schaltungen unter weitgehendster Einschränkung des Einsatzes der genannten Klebefolien (Acrylat-Polyesterfolie oder Noflow-Prepregs) herstellen, wobei auch die in Verbindung mit dem bekannten Verfahren erläuterten Nachteile vollständig beseitigt werden.

Im einzelnen kann die Erfindung dadurch eine vorteilhafte Ausgestaltung erfahren, daß das Klebemittel mit dem endlichen Klebemittelfluß lediglich an Übergangsstellen von den starren zu den flexiblen Abschnitten einer starrflexiblen Mehrlagenschaltung eingesetzt wird, wobei diese Übergangsstellen nur wenige Millimeter breit sein können. Durch die Verwendung dieses Klebemittels an den genannten Übergangsstellen wird während des Laminiervorganges unter Druck und Temperatureinfluß wirksam ein Übertritt des fließenden Harzes auf die flexiblen Teile verhindert und es werden die genannten Bereiche verklebt.

Dies hat zur Folge, daß die spätere Stabilität des gesamten Werkstoffverbundes hauptsächlich durch ein und dasselbe glasfaserverstärkte Harzsystem mit ursprünglich endlichem Harzfluß, das heißt also mit einem Harzfluß gleich oder deutlich größer als 5 % bestimmt wird, wobei die Art der Harzmatrix (Epoxid-Polyimidbasis o.ä.) für das Verfahren selber in keiner Weise nachteilig ist.

Das Klebemittel mit dem endlichen Klebemittelfluß dichtet aufgrund von Adhäsion/Kohäsion und/oder chemischer Reaktion die zu schützenden Abschnitte mechanisch ab und verklebt diese.

Das Klebemittel mit dem endlichen Harzfluß kann in der verschiedensten Weise ausgeführt sein und beispielsweise aus einer festen Kleberfolie, einer kleberbeschichteten Folie, einem flüssigen oder pastösen oder gefülltem Kleber oder Kombinationen aus diesen Kleberarten bestehen. Das Klebemittel kann ferner aus einem Ein- oder Zweikomponentenkleber, einem maskierten Reaktivkleber oder einer anorganischen/organischen Klebematrix bestehen. Schließlich kann das Klebemittel auch in Form von Prepregs mit endlichem Harzfluß vorgesehen werden. Die genannten vor einer Klebemittelbenetzung zu schützenden Abschnitte können aus Kanälen, tiefergelegten Ebenen oder Vertiefungen der Mehrlagenschaltung bestehen.

Im folgenden wird die Erfindung anhand von Ausführungsbeispielen unter Hinweis auf die Zeichnung näher erläutert. Es zeigen:

Figur 1    eine schematische Schnittdarstellung einer Gedruckten Schaltung in Mehrlagentechnik, die gemäß einem herkömmlichen Verfahren hergestellt wurde;

Figur 2    eine schematische Schnittdarstellung einer Gedruckten Schaltung in Mehrlagentechnik mit Merkmalen nach der Erfindung; und

Figur 3    ein weiteres Ausführungsbeispiel einer Gedruckten Schaltung in Mehrlagentechnik, die mit Hilfe des erfindungsgemäßen Verfahrens hergestellt wurde.

Figur 2 zeigt eine schematische Schnittdarstellung einer Gedruckten Schaltung in Mehrlagentechnik, die nach dem erfindungsgemäßen Verfahren hergestellt wurde. Die gezeigte Gedruckte Schaltung umfaßt einen Außenkern 5 mit Leiterbild, einen flexiblen Innenkern 6 mit Leiterbild und schließlich einen weiteren bzw. unteren Außenkern 7 mit Leiterbild. Mit 8 ist eine vorverpresste Deckfolie bezeichnet. Mit 9 ist ein herkömmlicher Prepreg bezeichnet, dessen nachteiliger Einfluß auf einen zu schützenden Bereich (der Bereich entsprechend der vorverpressten Deckfolie 8) mit Hilfe einer Kleberdichtung 10 verhindert wird. Die an den Übergangsstellen von starren zu starrflexiblen Abschnitten der gezeigten Mehrlagenschaltung eingesetzten Kleberdichtungen bzw. Klebstoffe (Klebefolien, flüssige oder pastöse Kleber usw.) verhindern einen Harzübertritt an den Übergangsstellen, wodurch nach Fertigstellung einer Gedruckten Schaltung eine ausgezeichnete Zuverlässigkeit insbesondere wesentlich verbesserte thermische Stabilität erreicht wird. Die in Verbindung mit dem bekannten Verfahren erläuterten Nachteile werden aufgrund der Kleberdichtungen 10 vollständig beseitigt.

Die in Figur 2 gezeigte Kleberdichtung läßt sich mit jeder Art von fester Kleberfolie, kleberbeschichteten Folie, einem flüssigen, pastösen oder gefülltem Kleber unabhängig von der Art der Klebermatrix und unabhängig von der chemischen Struktur derselben realisieren. Die Kleberdichtung kann aus einem Ein/Zweikomponentenkleber, einem maskierten Reaktivkleber, einer anorganischen/organischen Klebermatrix bestehen.

Die Kleberdichtung 10 wird natürlich vor dem Fließvorgang des Prepregharzes 9 in Lage gebracht und sie kann aufgrund von Adhäsion/Kohäsion und/oder chemischer Reaktion die Übergangsstellen von starren zu flexiblen Teilen mechanisch abdichten und verkleben.

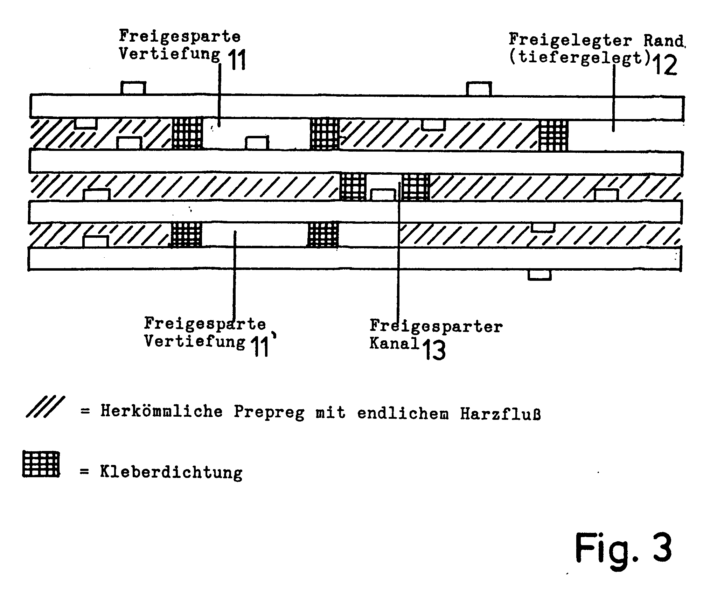

Das erfindungsgemäße Verfahren kann auch zur Herstellung von starren Mehrlagenschaltungen angewandt werden, wobei ein Beispiel einer solchen starren Mehrlagenschaltung in Figur 3 veranschaulicht ist. Diese Mehrlagenschaltung bzw. gedruckte Schaltung kann sehr verschiedene Abschnitte am Innen- oder Außenkern aufweisen, wie beispielsweise freigesparte Vertiefungen 11, freigesparte Vertiefungen 11´, freigesparte Kanäle 13 oder freigelegte Ränder bzw. tiefergelegte Randbereiche 12.

In Figur 3 ist die Lage der Kleberdichtungen durch die doppelt schraffierten Felder angegeben. Die einfach schraffierten Felder geben die Lage von herkömmlichen Prepregs an.

Das Verfahren nach der vorliegenden Erfindung ist nicht auf die gezeigten Ausführungsbeispiele von Gedruckten Schaltungen beschränkt, sondern läßt sich auch unter Erzielung der gleichen Wirkungen und Vorteile bei Gedruckten Schaltungen mit Einlagentechnik realisieren.

## Patentansprüche

1.    Verfahren zur Herstellung von Gedruckten Schaltungen in starrer oder starrflexibler Mehrlagentechnik, wonach unter Verwendung von Klebemitteln, insbesondere Klebefolien, ein Laminat, welches eine oder mehrere Leiterbildschichten (5-7), eine oder mehrere Klebemittelschichten (9) und gegebenenfalls Schutz- oder Deckschichten (8) enthält, unter Anwendung von Druck und Temperatur hergestellt wird, dadurch **gekennzeichnet,** daß zumindest ein Teil der Umgebung von Abschnitten des Laminats, die vor einer Klebemittelbenetzung zu schützen sind, mit einem weiteren Klebemittel (10) versehen wird, welches bei der Temperatur-und Druckbeeinflussung einen endlichen Klebemittelfluß hat, der gleich oder kleiner 5 % ist.

**2.** Verfahren nach Anspruch 1, dadurch **gekennzeichnet,** daß das weitere Klebemittel mit dem endlichen Klebemittelfluß an Übergangsstellen von den starren zu den flexiblen Abschnitten einer starrflexiblen Mehrlagenschaltung vorgesehen wird.

**3.** Verfahren nach Anspruch 1 oder 2, dadurch **gekennzeichnet,** daß das weitere Klebemittel mit dem endlichen Klebemittelfluß aufgrund von Adhäsion/Kohäsion und/oder chemischer Reaktion die zu schützenden Abschnitte mechanisch abdichtet und verklebt.

**4.** Verfahren nach einem der Ansprüche 1 bis 3, dadurch **gekennzeichnet,** daß als weiteres Klebemittel mit dem endlichen Klebemittelfluß eine feste Kleberfolie, eine kleberbeschichtete Folie, ein flüssiger, ein pastöser oder gefüllter Kleber oder Kombinationen dieser Kleberarten verwendet wird.

**5.** Verfahren nach Anspruch 4, dadurch **gekennzeichnet,** daß das weitere Klebemittel aus einem Ein/Zweikomponentenkleber, einem maskierten Reaktivkleber oder einer anorganischen/organischen Klebematrix besteht.

**6.** Verfahren nach einem der vorangegangenen Ansprüche, dadurch **gekennzeichnet,** daß das Klebemittel vor dessen Benetzung das weitere Klebemittel schützt, aus Prepregs mit endlichem Harzfluß besteht.

**7.** Verfahren nach Anspruch 6, dadurch **gekennzeichnet,** daß das Klebemittel bzw. die Prepregs aus einem Acrylat-oder Polyesterharzmaterial besteht bzw. bestehen.

**8.** Verfahren nach Anspruch 6, dadurch **gekennzeichnet,** daß als Klebemittel bzw. als Prepregs ein glasfaserverstärktes Epoxidmaterial verwendet wird.

**9.** Verfahren nach einem der vorangegangenen Ansprüche, dadurch **gekennzeichnet,** daß bei der Herstellung einer Mehrlagenschaltung das Klebemittel bzw. die Prepregs mit dem endlichen Harzfluß in Kombination mit Noflow-Prepregs eingesetzt wird bzw. werden.

**10.** Verfahren nach Anspruch 1, dadurch **gekennzeichnet,** daß die Abschnitte aus Kanälen (13), tiefergelegten Ebenen (12) oder Vertiefungen (11, 11') der Mehrlagenschaltung gebildet sind.

**Claims**

**1.** A method of producing printed circuits employing rigid or rigid-flexible multi-layer technology, by which, while using adhesives, particularly adhesive films, a laminate is produced which contains one or a plurality of conductive pattern layers (5-7), one or a plurality of adhesive layers (9) and possibly protective or top layers (8), with the application of pressure and temperature, characterised in that at least a part of the surround of portions of the laminate which have to be protected from being touched by an adhesive, is provided with a further adhesive (10) which under the influence of temperature and pressure, displays a finite flow of adhesive which is equal to or less than 5%.

**2.** A method according to Claim 1, characterised in that the further adhesive with the finite flow of adhesive is provided at the transitions from the rigid to the flexible portions of a rigid-flexible multi-layer circuit.

**3.** A method according to Claim 1 or 2, characterised in that the further adhesive with the finite flow of adhesive mechanically seals and glues the portions which are to be protected, as the result of adhesion, cohesion and/or chemical reaction.

**4.** A method according to one of Claims 1 to 3, characterised in that a solid adhesive film, an adhesive-coated film, a liquid, pasty or filled glue or combinations of these types of adhesive may be used as the further adhesive with the finite adhesive flow.

**5.** A method according to Claim 4, characterised in that the further adhesive consists of a single/two-component glue, a masked reactive glue or an inorganic/organic glue matrix.

**6.** A method according to one of the preceding Claims, characterised in that the adhesive against contact with which the further adhesive affords protection, consists of prepregs with a finite resin flow.

**7.** A method according to Claim 6, characterised in that the adhesive or the prepregs consists or consist of an acrylate or polyester resin material.

**8.** A method according to Claim 6, characterised in that a glass fibre reinforced epoxy material is used as the adhesive or as the prepregs.

9. A method according to one of the preceding Claims, characterised in that where a multi-layer circuit is being produced, the adhesive or the prepregs with the finite resin flow is or are used in combination with noflow prepregs.

10. A method according to Claim 1, characterised in that the portions are formed from channels (13), lowered levels (12) or depressions (11, 11') in the multi-layer circuit.

**Revendications**

1. Procédé de fabrication de circuits imprimés par une technique à plusieurs couches, rigide ou rigide-flexible dans lequel, en utilisant des adhésifs, en particulier des feuilles de collage, on fabrique un stratifié qui contient une ou plusieurs couches conductrices images (5-7) ou une ou plusieurs couches d'adhésif (9) et le cas échéant des couches de protection et de revêtement (8) caractérisé en ce qu'au moins une partie du pourtour de sections du stratifié qui doivent être protégées d'un mouillage d'adhésif est munie d'un autre adhésif (10) qui, sous l'effet de la température et de la pression, présente un écoulement d'adhésif limite qui est égal ou inférieur à 5%.

2. Procédé selon la revendication 1, caractérisé en ce que l'autre adhésif présentant un écoulement d'adhésif limité est prévu aux endroits de transition entre les sections rigides et flexibles d'un circuit multicouche rigide-flexible.

3. Procédé selon la revendication 1 ou 2, caractérisé en ce que l'autre adhésif présentant l'écoulement d'adhésif limité rend étanche et colle mécaniquement les sections à protéger par adhérence-cohésion et/ou par une réaction chimique.

4. Procédé selon l'une des revendications 1 à 3, caractérisé en ce qu'on utilise comme autre adhésif ayant l'écoulement d'adhésif limité une feuille de collage solide, une feuille enduite de colle, une colle liquide, pâteuse ou chargée, ou des combinaisons de ces types de colle.

5. Procédé selon la revendication 4, caractérisé en ce que l'autre adhésif se compose d'une colle à un/deux constituants, d'une colle réactive masquée ou d'une matrice de colle minérale/organique.

6. Procédé selon l'une des revendications précédentes, caractérisé en ce que l'adhésif que l'autre adhésif protège du mouillage se compose de prepregs ayant un écoulement de résine limité.

7. Procédé selon la revendication 6, caractérisé en ce que l'adhésif ou les prepregs se compose ou se composent d'une matière de résine acrylate ou polyester.

8. Procédé selon la revendication 6, caractérisé en ce qu'on utilise comme adhésif ou comme prepregs une matière d'époxyde renforcée de fibres de verre.

9. Procédé selon l'une des revendications précédentes, caractérisé en ce que, lors de la fabrication d'un circuit à plusieurs couches, on utilise l'adhésif ou les prepregs ayant un écoulement de résine limité en association avec des Noflow Prepregs.

10. Procédé selon la revendication 1, caractérisé en ce que les sections sont constituées de canaux (13) de surfaces en contrebas (12) ou de cavités (11, 11') du circuit multicouche.

EP 0 299 454 B1

Fig.1

1
2
3

Zu verklebender
Bereich

Freizusparender
Bereich

Zu verklebender
Bereich

4

Fig. 2

5
6
7

8
9
10

6

EP 0 299 454 B1

Freigesparte
Vertiefung 11

Freigelegter Rand
(tiefergelegt) 12

Freigesparte
Vertiefung 11'

Freigesparter
Kanal 13

/// = Herkömmliche Prepreg mit endlichem Harzfluß

▦ = Kleberdichtung

# Fig. 3